# EUROPÄISCHE PATENTANMELDUNG

(11) **EP 2 458 709 A1**
(43) Veröffentlichungstag der Anmeldung: **30.05.2012**
(21) Anmeldenummer: 11188528.1
(22) Anmeldetag: 10.11.2011
(51) Int. Cl.: H02J 13/00, H03K 17/94, H04B 1/40, H04W 52/02, H04B 1/04

(54) **Funksystem mit Generator und Zusatzspeicher**

(30) Priorität: 30.11.2010 DE 202010013013 U
(71) Anmelder: steute Schaltgeräte GmbH & Co. KG, 32584 Löhne (DE)
(72) Erfinder: Twellmann, Ralf, 31683 Obernkirchen (DE); Hofmann, Andreas, 32257 Bünde (DE); Schmidt, Marc, 32120 Hiddenhausen (DE)
(74) Vertreter: Habbel, Ludwig

(57) **Zusammenfassung**

Die Erfindung bezieht sich auf ein Funksystem,
mit einem ein Funksignal aussenden Sender,
und einem das Funksignal empfangenden Empfänger,
wobei dem Sender ein Generator zugeordnet ist, derart, dass der Sender energieautark unabhängig von einer Netzstromversorgung betreibbar ist, und wobei der Sender als Transceiver ausgestaltet und auf den Empfänger den Aufbau einer bidirektionalen Funkverbindung ermöglichend abgestimmt ist, derart, dass vom Empfänger den Empfang des Funksignals bestätigende Diagnosedaten an den Sender übermittelbar sind,
und dass dem Sender ein Energiespeicher für elektrische Energie zugeordnet ist, sowie eine Schaltung, welche die Energieversorgung des Senders derart steuert, dass das Versenden des Funksignals mittels der vom Generator erzeugten Energie und das Empfangen der Diagnosedaten mittels der im Energiespeicher gespeicherten Energie erfolgt.

## Beschreibung

Die Erfindung betrifft ein Funksystem nach dem Oberbegriff des Anspruchs 1.

Aus der Praxis sind gattungsgemäße Funksysteme bekannt, bei denen beispielsweise Solarzellen, induktive, Piezo-, Vibrations- oder solche Generatoren verwendet werden, die ihre Energie aus einer Temperaturdifferenz der Umgebungstemperatur beziehen. Durch diese Generatoren ist es möglich, die Sender der bekannten Funksysteme unabhängig von beispielsweise einem anlageninternen, betriebsinternen oder öffentlichen Stromnetz zu betreiben. Insbesondere wenn es sich bei den bekannten Funksystemen um Schalter handelt, die eine Anlage oder einen anderweitigen Verbraucher ein- oder ausschalten können, ist üblicherweise im Bereich dieses Verbrauchers eine ausreichende Energieversorgung zum Betreiben dieses Verbrauchers vorhanden, so dass der Empfänger des Funksystems nicht energieautark ausgelegt sein muss, sondern mittels derselben Energieversorgung betrieben werden kann wie der Verbraucher.

Bei den bekannten Funksystemen ist nachteilig, dass die verwendeten Generatoren üblicherweise eine sehr geringe Energieausbeute liefern. Dies äußert sich in zweifacher Hinsicht: Erstens wird auf Grund der geringen bereitgestellten Energiemenge auch nur eine geringe Sendeleistung des Senders ermöglicht, so dass beispielsweise die Funkreichweite des Senders stark begrenzt ist. Zweitens ist die Zeitdauer, während welcher der Sender betrieben werden kann, auf Grund der geringen bereitgestellten elektrischen Energiemenge auf eine sehr kurze Zeitspanne begrenzt, die beispielsweise nicht ausreicht, um im Rahmen einer bidirektionalen Datenübermittlung ein Bestätigungssignal bzw. Diagnosedaten, die vom Empfänger ausgesendet werden, im Bereich des Senders zu empfangen. Für besonders sicherheitsrelevante Schaltvorgänge können die bekannten Funksysteme daher nicht verwendet werden, da weder erkannt werden kann, ob ein gesendetes Funksignal beim Empfänger korrekt angekommen oder verarbeitet worden ist, noch eine gesicherte Übertragung des Funksignals anschließend protokolliert werden kann.

Der Erfindung liegt die Aufgabe zugrunde, ein gattungsgemäßes Funksystem dahingehend zu verbessern, dass dieses eine verbesserte Leistungsfähigkeit aufweist, unter Beibehaltung einer über Jahre wirksamen, energieautarken Ausgestaltung des Senders.

Diese Aufgabe wird durch ein Funksystem mit den Merkmalen des Anspruchs 1 gelöst.

Die Erfindung schlägt mit anderen Worten vor, den Sendebetrieb zur Aussendung des Funksignals nach wie vor durch den Generator zu ermöglichen, welcher dem Sender zugeordnet ist, zusätzlich jedoch einen Energiespeicher bereitzustellen, der allerdings nicht das Aussenden des Funksignals ermöglicht, sondern vielmehr für Funktionen zur Energieversorgung dient, die einen sehr viel geringeren Energieverbrauch aufweisen. Daher kann die gesamte vom Generator bereitgestellte Energie zur Aussendung des Funksignals verwendet werden, so dass auf diese Weise ein optimal starkes Funksignal mit einer dementsprechend großen Reichweite ermöglicht wird. Zudem liegt ein zweiter Vorteil des vorschlagsgemäßen Funksystems in der Möglichkeit, den Sender als Transceiver auszugestalten und diesen, unterstützt durch den Energiespeicher, eine ausreichend lange Zeit in der Form zu betreiben, dass vom Empfänger des Funksignals ausgesandte Diagnosedaten empfangen und protokolliert werden können.

Da diese Energiemengen gering sind im Vergleich zu der erforderlichen elektrischen Energie für die Aussendung des Funksignals, wird der elektrische Energiespeicher nur minimal belastet und kann über etliche Jahre eine ausreichende Versorgung des Transceivers für die beschriebenen Dienste sicherstellen. Wenn auch im streng wissenschaftlichen Sinn der Sender aufgrund des verwendeten Energiespeichers nicht vollkommen energieautark ausgestaltet ist, so ist doch im Sinne einer praktischen Benutzung der Sender als "energieautark" zu bezeichnen, da er keine kurzen Wartungsintervalle erfordert, eine Montage des Senders unabhängig von einer bestehenden Infrastruktur der Energieversorgung ermöglicht und je nach Anwendungsfall sogar während der gesamten Nutzungsdauer einer Anlage wartungsfrei nutzbar sein kann.

Vorteilhaft kann der Empfang der vom Empfänger zum Sender zurückgesandten Diagnosedaten mittels der im Energiespeicher gespeicherten Energie ermöglicht werden, wobei die Schaltung des Transceivers so ausgestaltet ist, dass sie diese Empfangsbereitschaft des Transceivers zum Empfang der Diagnosedaten ausreichend lange aufrechterhält.

Dabei kann insbesondere vorteilhaft vorgesehen sein, dass auch die Abspeicherung der Diagnosedaten selbst mittels der im Energiespeicher gespeicherten Energie erfolgt. Die dafür erforderlichen Energiemengen sind sehr gering, so dass insgesamt die Funktionsfähigkeit des Funksystems über einen langen Zeitraum beibehalten werden kann.

Je nach Schaltfunktion und Anwendungsgebiet des Funksystems kann die Protokollierung von Diagnosedaten entbehrlich sein: wenn beispielsweise der Sender als Schalter ausgestaltet ist, der bei Betätigung ein Schaltsignal aussendet, kann je nachdem, mit welchem nachgeschalteten Verbraucher das Funksystem zusammenwirkt, die erfolgreiche Übermittlung des Schaltsignals unmittelbar am Verhalten des Verbrauchers erkennbar sein, beispielsweise wenn Beleuchtungseinrichtungen ein- oder ausgeschaltet werden. Bei sicherheitsrelevanten Anwendungen jedoch kann auch für solche Schaltvorgänge vorteilhaft vorgesehen sein, dass sämtliche Aussendungen von Funksignalen protokolliert werden. In diesem Fall kann vorteilhaft vorgesehen sein, dass der Empfänger als Transceiver ausgestaltet ist und im Sinne einer bidirektionalen Kommunikation ein Bestätigungssignal bzw. Diagnosedaten an den Sender zurücksendet, wo diese gespeichert werden können.

Ein Ausführungsbeispiel der Erfindung wird anhand der rein schematischen Darstellungen näher erläutert.

Dabei ist in Form eines Blockschaltbildes der Aufbau eines Schalters dargestellt, der im Rahmen seiner energieautarken Ausgestaltung einen Generator 1 aufweist, welcher einerseits eine Logikschaltung 3 und andererseits einen Transceiverbaustein 5 mit elektrischer Energie versorgt.

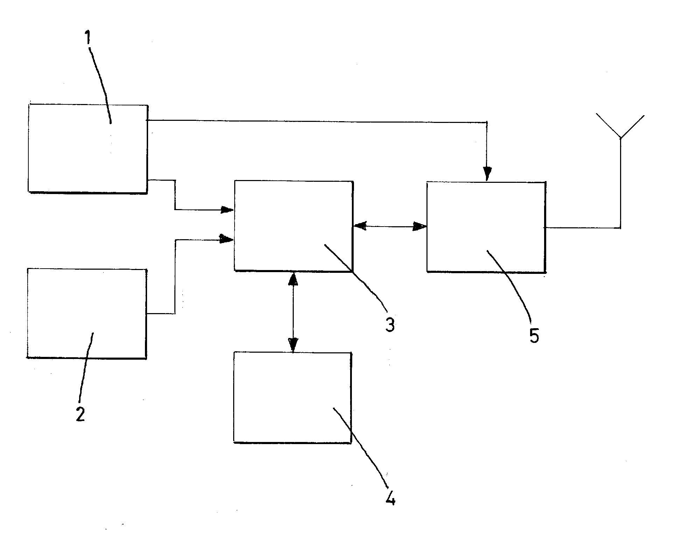

Vom Transceiverbaustein 5 kann bei Betätigung des Schalters ein entsprechendes Funksignal bzw. Schaltsignal ausgesandt werden, wie dies in der Zeichnung rechts vom Transceiverbaustein 5 angedeutet ist. Die Logikschaltung 3 ist dabei so ausgestaltet, dass von der Energie, welche der Generator 1 bereitstellt, ein geringer Anteil zum Betrieb der Logikschaltung 3 verbraucht wird und der gesamte Rest der Energie dem Transceiverbaustein 5 zugeführt wird, so dass ein entsprechend starkes und weit reichendes Funksignal ausgesendet werden kann. Außer dem Generator 1 ist eine weitere Energiequelle vorgesehen, nämlich eine permanente Energiequelle, die nicht nur bei Betätigung des Schalters Energie bereitstellt, sondern die als Energiespeicher 2 ausgestaltet ist, beispielsweise in Form einer Batterie.

Auch diese Energiequelle in Form des Energiespeichers 2 versorgt die Logikschaltung 3 mit elektrischer Energie, so dass die Logikschaltung 3 beispielsweise zur Protokollierung der Schaltvorgänge entsprechende Daten in ein EEPROM 4 schreiben kann. Wenn vom Empfänger des Schaltsignals Diagnosedaten zurückgesandt und von dem Transceiverbaustein 5 empfangen werden, werden diese Diagnosedaten von dem Transceiverbaustein 5 zu der Logikschaltung 3 übermittelt und in das EEPROM 4 geschrieben, wobei die hierzu erforderliche Energie von dem Energiespeicher 2 bereitgestellt wird und erheblich geringer ist als die Energie, die zum Aussenden des Funksignals durch den Transceiverbaustein 5 erforderlich ist.

Im Vergleich zu einem batteriebetriebenen oder akkubetriebenen Funkschalter, bei dem die Aussendung des Funksignals batterie- oder akkugestützt erfolgt, kann daher der dargestellte Aufbau eines Funksystems als unter praktischen Gesichtspunkten energieautark bezeichnet werden, da die zum Versenden des Schaltsignals erforderliche Energie über den Generator 1 erzeugt wird und ohne Fremdenergie auskommt. Durch den zusätzlich vorgesehenen Energiespeicher 2 kann ein vorschlagsgemäß ausgestalteter, energieautarke Schalter auch für sicherheitsrelevante Anwendungen genutzt werden, bei denen eine Dokumentation der Schaltvorgänge vorgesehen ist, oder bei denen zumindest bei der Ausführung jedes einzelnen Schaltvorgangs vorgesehen ist, dass ein Bestätigungssignal des Empfängers vorliegen muss, welches die Durchführung des gewünschten Schaltvorgangs bestätigt oder zumindest den Empfang des vom Funkschalter ausgesendeten Funksignals bzw. Schaltsignals.

## Patentansprüche

1. Funksystem,
mit einem ein Funksignal aussenden Sender,
und einem das Funksignal empfangenden Empfänger, wobei dem Sender ein Generator zugeordnet ist, derart, dass der Sender energieautark unabhängig von einer Netzstromversorgung betreibbar ist,
**dadurch gekennzeichnet,**
**dass** der Sender als Transceiver ausgestaltet und auf den Empfänger den Aufbau einer bidirektionalen Funkverbindung ermöglichend abgestimmt ist, derart, dass vom Empfänger den Empfang des Funksignals bestätigende Diagnosedaten an den Sender übermittelbar sind,
und **dass** dem Sender ein Energiespeicher (2) für elektrische Energie zugeordnet ist,
sowie eine Schaltung (3), welche die Energieversorgung des Senders derart steuert, dass das Versenden des Funksignals mittels der vom Generator (1) erzeugten Energie und das Empfangen der Diagnosedaten mittels der im Energiespeicher (2) gespeicherten Energie erfolgt.

2. Funksystem nach Anspruch 1,
**dadurch gekennzeichnet,**
**dass** die Schaltung (3) die Empfangsbereitschaft des Transceivers so lange aufrechterhaltend ausgestaltet ist, bis die vom Empfänger zurückgesendeten Diagnosedaten sicher abgespeichert sind.

3. Funksystem nach Anspruch 2,
**dadurch gekennzeichnet,**
**dass** die Schaltung (3) die Energieversorgung des Senders derart steuert, dass auch die Abspeicherung der Diagnosedaten mittels der im Energiespeicher (2) gespeicherten Energie erfolgt.

4. Funksystem nach einem der vorhergehenden Ansprüche,
**dadurch gekennzeichnet,**
**dass** auch der Empfänger als Transceiver ausgestaltet ist.

5. Funksystem nach einem der vorhergehenden Ansprüche,
**dadurch gekennzeichnet,**
**dass** der Sender als Schalter ausgestaltet ist, welcher bei Betätigung ein Schaltsignal aussendet.
